(19) Europäisches Patentamt / European Patent Office / Office européen des brevets

(11) **EP 3 207 390 B1**

(12) **FASCICULE DE BREVET EUROPEEN**

(45) Date de publication et mention de la délivrance du brevet:
**01.12.2021 Bulletin 2021/48**

(21) Numéro de dépôt: **15805566.5**

(22) Date de dépôt: **16.10.2015**

(51) Int Cl.:
*G01R 31/36* (2020.01)     *H01M 10/48* (2006.01)
*H02J 7/00* (2006.01)

(86) Numéro de dépôt international:
**PCT/FR2015/052786**

(87) Numéro de publication internationale:
**WO 2016/059355 (21.04.2016 Gazette 2016/16)**

(54) **PROCÉDÉ POUR DIAGNOSTIQUER DES DÉFAILLANCES DANS UN ENSEMBLE DE BATTERIES STATIONNAIRES**

VERFAHREN ZUR DIAGNOSE VON DEFEKTEN IN EINEM SATZ AUS STATIONÄREN BATTERIEN

METHOD FOR DIAGNOSING DEFECTS IN A SET OF STATIONARY BATTERIES

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **17.10.2014 FR 1460028**

(43) Date de publication de la demande:
**23.08.2017 Bulletin 2017/34**

(73) Titulaire: **Renault S.A.S.**
**92100 Boulogne-Billancourt (FR)**

(72) Inventeurs:
- **BEN-AICHA, Fehd**
  **78280 Guyancourt (FR)**
- **TRINH, Do-Hieu**
  **78330 Fontenay-le-fleury (FR)**
- **TOUSSAINT, Philippe**
  **78000 Versailles (FR)**

(56) Documents cités:
EP-A1- 2 720 343     WO-A1-2013/094057
WO-A2-2008/152238     US-A1- 2011 227 414

EP 3 207 390 B1

Il est rappelé que: Dans un délai de neuf mois à compter de la publication de la mention de la délivrance du brevet européen au Bulletin européen des brevets, toute personne peut faire opposition à ce brevet auprès de l'Office européen des brevets, conformément au règlement d'exécution. L'opposition n'est réputée formée qu'après le paiement de la taxe d'opposition. (Art. 99(1) Convention sur le brevet européen).

**Description**

La présente invention concerne un procédé pour diagnostiquer des défaillances dans un ensemble de batteries stationnaires. Elle s'applique notamment aux installations de stockage d'énergies d'origines renouvelables de type éolien ou photovoltaïque.

Dans le contexte actuel de consensus autour du réchauffement climatique, la diminution des émissions de dioxyde de carbone ($CO_2$) est un défi majeur auquel sont confrontés toutes les industries, notamment les producteurs d'énergie et les constructeurs automobiles, les normes étant toujours plus exigeantes en la matière.

Dans le domaine de la construction automobile, outre l'amélioration constante des rendements des moteurs thermiques classiques, qui s'accompagne d'une baisse des émissions de $CO_2$, les véhicules électriques et les véhicules hybrides thermique-électrique sont aujourd'hui considérés comme la solution la plus prometteuse pour diminuer les émissions de $CO_2$. Dans la suite de la présente demande, l'expression « véhicules électriques » désigne indifféremment les véhicules électriques et les véhicules hybrides thermique-électrique, y compris les véhicules hybrides rechargeables.

Différentes technologies ont été envisagées pour concevoir des batteries de traction pour véhicule électrique, chacune présentant des avantages et des inconvénients. En particulier, la technologie lithium-ion (li-ion) offre un excellent compromis entre densité d'énergie et densité de puissance, idéal aux applications automobiles. Mais sa mise en œuvre n'est pas sans poser de nombreuses difficultés, tant pour des raisons techniques que pour des raisons économiques. En effet, les batteries li-ion utilisées pour la traction des véhicules électriques subissent une perte de capacité en fonction du temps et en fonction des conditions d'usages. A partir d'un certain seuil de capacité, l'autonomie de ces batteries n'est plus suffisante pour un usage automobile et il faut procéder à leur remplacement. Malheureusement, le coût de stockage et de recyclage des batteries li-ion est très élevé et vient pénaliser la profitabilité économique de ces batteries. C'est pourquoi la demanderesse travaille à prolonger la durée de vie de ces batteries, en proposant de les utiliser pour d'autres applications, notamment des applications stationnaires de stockage d'énergie électrique renouvelable de type éolien ou photovoltaïque, en vue d'alimenter des bâtiments en énergie électrique. En effet, en allongeant la durée d'amortissement du coût de la batterie, cela permet d'absorber son coût de recyclage et donc d'augmenter sa profitabilité économique. Ainsi, la demanderesse a développé un système de stockage d'énergie pour alimenter des bâtiments en énergie électrique, ce système utilisant des batteries « recyclées » dans le sens où elles ont eu une première utilisation ou « première vie » dans des véhicules électriques. On parle ainsi de « seconde vie » pour ces batteries. Toutefois, comme les batteries ont déjà vieilli, un soin tout particulier doit être apporté à la maintenance du système pour assurer les niveaux de sécurité et de performance requis. Il s'agit là d'un problème que la présente invention se propose de résoudre.

Le brevet EP2147323 divulgue un système de batteries stationnaires utilisé pour l'alimentation d'un bâtiment et comportant des moyens pour détecter des défaillances des batteries. Un inconvénient majeur de cette solution est qu'elle ne donne pas d'indication précise quant à l'origine des défaillances, laissant le travail de diagnostic précis à l'opérateur de maintenance. Il s'agit là encore d'un problème que la présente invention se propose de résoudre.

La présente invention a pour but de résoudre les inconvénients précités, notamment de fournir un diagnostic sur la réalisation de la consigne de charge ou de décharge de batteries stationnaires. A cet effet, l'invention a pour objet un procédé pour détecter des défaillances dans un système de stockage d'énergie électrique comportant au moins une batterie selon la revendication indépendante 1.

Dans un mode de réalisation encore plus avantageux, le compteur $C_j$ peut être incrémenté si $T_j$ est une durée inférieure à un seuil prédéterminé et $e_j$ dépasse un seuil prédéterminé en ampères, ou si $T_j$ est une durée supérieure au seuil prédéterminé et le ratio entre $e_j$ et une erreur moyenne prédéterminée pour ladite durée $T_j$ dépasse un ratio prédéterminé.

Par exemple, l'erreur moyenne $e_{T_j}(t_i^j)$ peut être calculée par :

$$e_{T_j}(t_i^j) = e_{T_j}^{RMS}(t_i^j) = \sqrt{\frac{1}{T}\int_{t_i^j}^{t_i^j + T_j}(I^{Bat}(\tau) - I^{cons}(\tau))^2 \, d\tau}$$

Dans un mode de réalisation tout particulièrement avantageux, le procédé peut comporter une étape de levée d'une alerte de défaillance, l'alerte pouvant inclure d'indiquer, si $T_j \leq seuil_1$, que la défaillance a pour origine une défaillance de connectique, où $seuil_1$ est un seuil temporel prédéterminé, si $seuil_1 \leq T_j \leq seuil_2$, que la défaillance a pour origine une défaillance de capteur, où $seuil_2$ est un seuil temporel prédéterminé, et si $seuil_2 \leq T_j$, que la défaillance a pour origine le vieillissement de la batterie.

La présente invention a également pour objet un système de stockage d'énergie électrique d'origine renouvelable comportant au moins une batterie, ainsi que des moyens matériels et des moyens logiciels pour mettre en œuvre un tel procédé pour détecter des défaillances.

La présente invention a enfin pour objet un bâtiment comportant un tel système.

La présente invention a pour principal avantage qu'elle permet non seulement de détecter les défaillances des batteries, mais également d'isoler les batteries défectueuses pour pouvoir les échanger, améliorant ainsi les performances, et de cibler la maintenance, améliorant ainsi les prestations offertes au client.

D'autres caractéristiques et avantages de l'invention apparaîtront à l'aide de la description qui suit faite en regard de dessins annexés qui illustrent :

- la figure 1, par un digramme d'architecture, un exemple de système dans lequel l'invention peut être mise en œuvre ;
- les figures 2a, 2b, 2c et 2d, par des graphes, un principe de l'invention de comparer une consigne de charge avec la réalisation de cette consigne ;
- les figures 3a, 3b et 3c, par des graphes, un exemple de réalisation du procédé selon l'invention.

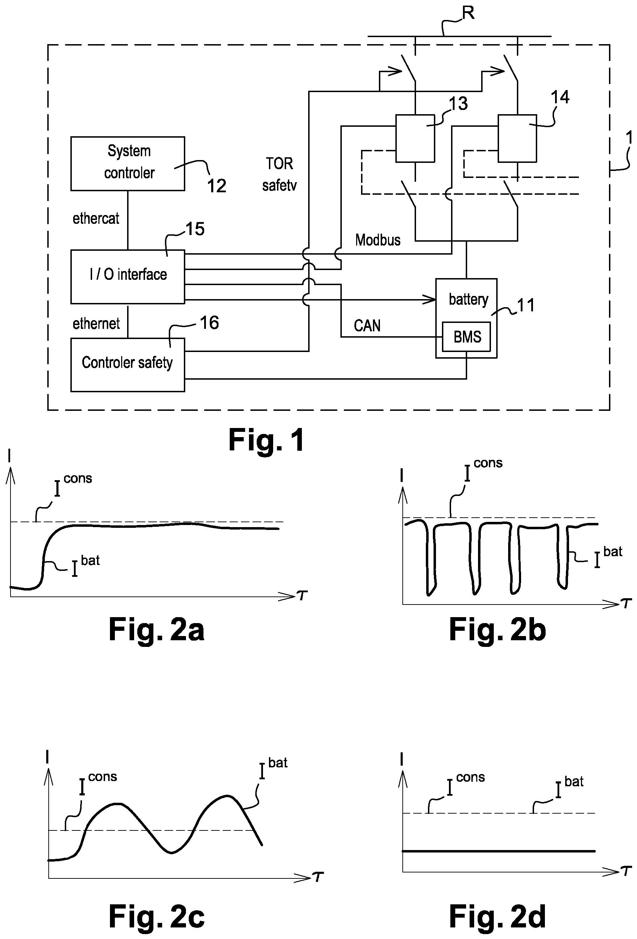

La figure 1 illustre un système 1 comportant une batterie 11 avec son système de contrôle de type BMS selon l'abréviation anglo-saxonne signifiant « Battery Management System », la batterie 11 étant reliée à un réseau R de distribution d'électricité par l'intermédiaire d'un système de charge et de décharge permettant de transformer un courant alternatif triphasé ou monophasé en courant continu, et vice-versa.

Pour répondre aux besoins en courant du bâtiment, un contrôleur principal du système 12 joue le rôle de superviseur des différents modules du système. En particulier, le procédé selon l'invention peut y être implémenté. Il envoie notamment une consigne de puissance P de charge (respectivement de décharge) vers un chargeur 13 (respectivement vers un onduleur 14). Un module d'interface 15 permet les communications entre les calculateurs et les autres organes du système, via des réseaux de type ethercat, ethernet, CAN et Modbus, dont l'utilisation est bien connue. Un contrôleur 16 est dédié au diagnostic des problèmes électriques au niveau matériel : si un problème est détecté, par exemple un court circuit, le calculateur 16 ouvre des disjoncteurs non représentés sur les figures disposés entre le réseau R et le chargeur 13 et l'onduleur 14. Etant donnée la mesure de la tension U aux bornes de la batterie 11, la consigne de puissance P peut être interprété comme une consigne de courant I de charge (respectivement de décharge) via la relation P=Uxl. Un principe de l'invention illustré par les figures 2a à 2d est de comparer l'évolution au cours du temps $\tau$ du courant mesuré $I^{bat}$ traversant réellement la batterie 11 avec la consigne de courant $I^{cons}$. Concrètement, l'invention propose de calculer l'erreur entre la consigne de courant $I^{cons}$ et le courant mesuré $I^{bat}$. Ainsi, la figure 2a illustre cette comparaison dans un cas idéal sans défaillance : le courant mesuré $I^{bat}$ est illustré par une ligne continue alors que la consigne de courant $I^{cons}$ est illustrée par une ligne discontinue. L'erreur peut être calculée lorsque le système est en phase de charge ou lorsqu'il est en phase de décharge, ceci de façon indifférente.

Un autre principe de l'invention est de calculer cette erreur dans des fenêtres temporelles glissantes de durées variables. Ceci permet de déduire la fréquence à laquelle la défaillance apparaît et de cibler le remède approprié en fonction de cette fréquence. Les figures 2b, 2c et 2d illustrent trois gammes de fréquence et donc trois types de défaillance qui peuvent être discriminées par l'invention : la figure 2b illustre les défaillances à hautes fréquences (elles se répètent souvent, par exemple 4 fois dans l'intervalle temporel considéré à la figure 2b), qui caractérisent un problème de connectique, la figure 2c illustre les défaillances à fréquences moyennes (elles se répètent moins souvent, par exemple 2 fois dans l'intervalle temporel considéré à la figure 2c), qui caractérisent les problèmes de capteurs, et la figure 2d illustre les défaillances à basses fréquences (elles sont permanentes dans l'intervalle temporel considéré à la figure 2d) qui caractérisent des problèmes de vieillissement.

L'erreur moyenne entre le courant de consigne $I^{cons}$ et le courant mesuré $I^{bat}$ dans une fenêtre temporelle de durée T s'étendant entre un instant t et l'instant t+T peut par exemple être donnée par la moyenne quadratique :

$$e_T^{RMS}(t) = \sqrt{\frac{1}{T}\int_t^{t+T}(I^{Bat}(\tau) - I^{cons}(\tau))^2 \, d\tau}$$

où l'abréviation RMS signifie « Root Mean Square » selon la terminologie anglo-saxonne désignant la moyenne quadratique.

Puis, l'erreur maximale sur toutes les fenêtres temporelle de durée T considérées est donnée par :

$$e_{max}^{RMS}(T) = \max_t (e_T^{RMS}(t))$$

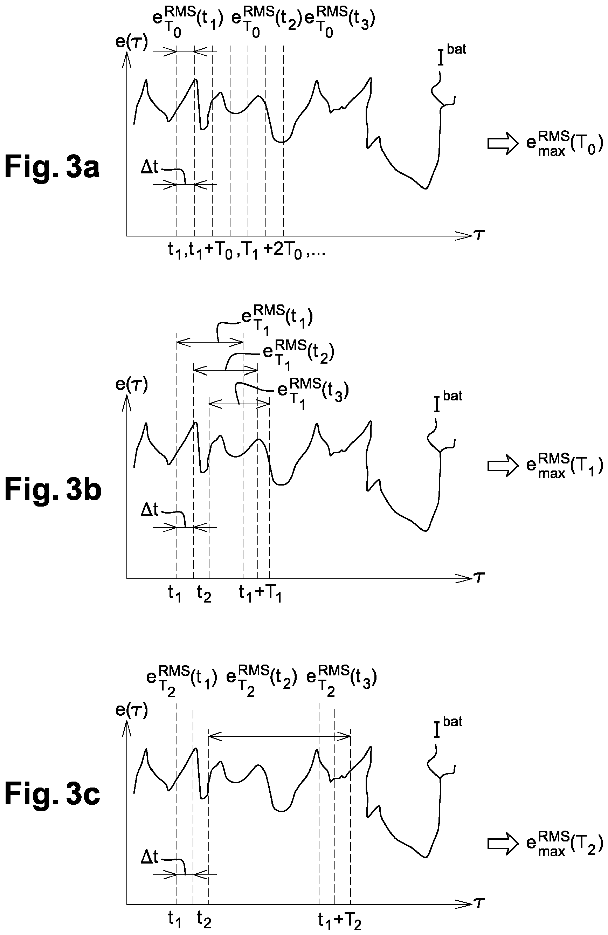

Les figures 3a, 3b et 3c illustrent, pour un même profil de courant $I^{bat}$ donné en fonction du temps $\tau$, les étapes de calcul selon l'invention de l'erreur maximale $e_{max}^{RMS}(T_j)$.

Tout d'abord, comme illustré par la figure 3a, une erreur $e_{T_0}^{RMS}(t_1)$ est calculée sur une première fenêtre temporelle de durée $T_0$ entre un instant $t_1^0$ et un instant $t_1^0+T_0$. Un pas d'échantillonnage temporel $\Delta t^0$ est alors choisi pour faire glisser la fenêtre temporelle du premier instant $t_1^0$ à un deuxième instant $t_2^0=t_1^0+\Delta t^0$. Puis, une erreur $e_{T_0}^{RMS}(t_2^0)$ est calculée sur une deuxième fenêtre temporelle de durée $T_0$ entre l'instant $t_2^0$ et un instant $t_2^0+T_0$. Puis, une erreur $e_{T_0}^{RMS}(t_3^0)$ est calculée sur une troisième fenêtre temporelle de durée $T_0$ entre un instant $t_3^0=t_2^0+\Delta t^0$ et un instant $t_3^0+T_0$. Et ainsi de suite, jusqu'à calculer une erreur $e_{T_0}^{RMS}(t_n^0)$ sur une n$^{ième}$ fenêtre temporelle de durée $T_0$ entre un instant $t_n^0=t_{n-1}^0+\Delta t^0$ et un instant $t_n^0+T_0$. L'erreur maximale $e_{max}^{RMS}(T_0)=\max\limits_{i=1,...,n}(e_{T_0}^{RMS}(t_i^0))$ est alors calculée.

Ensuite, comme illustré par la figure 3b, une erreur $e_{T_1}^{RMS}(t_1^1)$ est calculée sur une première fenêtre temporelle de durée $T_1$ plus longue que $T_0$ entre l'instant $t_1^1$ et un instant $t_1^1+T_1$. Un pas d'échantillonnage temporel $\Delta t^1$ est alors choisi pour faire glisser la fenêtre temporelle du premier instant $t_1^1$ à un deuxième instant $t_2^1=t_1^1+\Delta t^1$. Puis, une erreur $e_{T_1}^{RMS}(t_2^1)$ est calculée sur une deuxième fenêtre temporelle de durée $T_1$ entre l'instant $t_2^1$ et un instant $t_2^1+T_1$. Puis, une erreur $e_{T_1}^{RMS}(t_3^1)$ est calculée sur une troisième fenêtre temporelle de durée $T_1$ entre l'instant $t_3^1$ et un instant $t_3^1+T_1$. Et ainsi de suite, jusqu'à calculer une erreur $e_{T_1}^{RMS}(t_n^1)$ sur une n$^{ième}$ fenêtre temporelle de durée $T_1$ entre l'instant $t_n^1$ et un instant $t_n^1+T_1$. L'erreur maximale $e_{max}^{RMS}(T_1)=\max\limits_{i=1,...,n}(e_{T_1}^{RMS}(t_i^1))$ est alors calculée.

Ensuite, comme illustré par la figure 3c, une erreur $e_{T_2}^{RMS}(t_1^2)$ est calculée sur une première fenêtre temporelle de durée $T_2$ plus longue que $T_1$ entre l'instant $t_1^2$ et un instant $t_1^2+T_2$. Puis, une erreur $e_{T_2}^{RMS}(t_2^2)$ est calculée sur une deuxième fenêtre temporelle de durée $T_2$ entre l'instant $t_2^2$ et un instant $t_2^2+T_2$. Puis, une erreur $e_{T_2}^{RMS}(t_3^2)$ est calculée sur une troisième fenêtre temporelle de durée $T_2$ entre l'instant $t_3^2$ et un instant $t_3^2+T_2$. Et ainsi de suite, jusqu'à calculer une erreur $e_{T_2}^{RMS}(t_n^2)$ sur une n$^{ième}$ fenêtre temporelle de durée $T_2$ entre l'instant $t_n^2$ et un instant $t_n^2+T_2$. L'erreur maximale $e_{max}^{RMS}(T_2)=\max\limits_{i=1,...,n}(e_{T_2}^{RMS}(t_i^2))$ est alors calculée.

Le processus de calcul se poursuit ainsi m fois, jusqu'à calculer $e_{max}^{RMS}(T_m)=\max\limits_{i=1,...,n}(e_{T_m}^{RMS}(t_i^m))$ sur n fenêtres glissantes de durée Tm plus longues que les fenêtres $T_{m-1}$.

Le choix des durées $T_j$, pour $1 \leq j \leq m$, dépend du temps de réponse du système, c'est-à-dire du temps nécessaire pour atteindre la consigne désirée. C'est le temps d'établissement du courant dans le cas présent. Dans l'exemple de réalisation qui suit, des durées $T_1$=1s, $T_2$=10s, $T_3$= 100s, $T_4$=1000s et $T_5$=3600s ont été choisies.

A chaque fois que l'erreur maximale $e_{max}^{RMS}(T_j)$, où $1 \leq j \leq m$, dépasse un seuil prédéfini, un compteur de confirmation $C_j$ est incrémenté : si le compteur atteint lui-même un seuil prédéfinit par calibration, une défaillance est réputée détectée. Par contre, si au bout d'un certain délai prédéfini lui aussi, le seuil de confirmation n'est pas atteint, alors le compteur $C_j$ est remis à zéro.

Dans la suite de la présente demande, les termes défaut et défaillance sont utilisés indifféremment.

Première série de fenêtres glissantes :

- $T_0$ : 1 seconde (s)
- $\Delta t^0$ : 20 millisecondes (ms)
- Durée totale de l'observation entre $t_1^0$ et $t_n^0 + T_0$ : 10 s
- Chevauchement entre 2 fenêtres glissantes successives de durée $T_0$ : 400 ms
- Nombre de confirmations au compteur $C_0$ avant détection d'un défaut : 30 confirmations
- Temps avant remise à zéro du compteur $C_0$ si pas de défaut détecté : 30 minutes (min)

Ce qui signifie qu'un défaut qui se reproduit chaque seconde peut être confirmé au plus tôt en 5 minutes et au plus tard en 15 heures.

Deuxième série de fenêtres glissantes :

- $T_1$ : 10 s
- $\Delta t^1$ : 200 ms
- Durée totale de l'observation entre $t_1^1$ et $t_n^1 + T_1$ : 100 s
- Chevauchement entre 2 fenêtres glissantes successives de durée $T_1$ : 4 s
- Nombre de confirmations au compteur $C_1$ avant détection d'un défaut : 15 défauts
- Temps avant remise à zéro du compteur $C_1$ si pas de défaut détecté : 1 heure (h)

Ce qui signifie qu'un défaut qui se reproduit chaque seconde peut être confirmé au plus tôt en 25 minutes et au plus tard en 15 heures.

Troisième série de fenêtres glissantes :

- $T_2$ : 100 s
- $\Delta t^2$ : 2 s
- Durée totale de l'observation entre $t_1^2$ et $t_n^2 + T_2$ : 1000 s
- Chevauchement entre 2 fenêtres glissantes successives de durée $T_2$ : 40 s
- Nombre de confirmations au compteur $C_2$ avant détection d'un défaut : 5 défauts
- Temps avant remise à zéro du compteur $C_2$ si pas de défaut détecté : 5 h

Ce qui signifie qu'un défaut qui se reproduit chaque seconde peut être confirmé au plus tôt en 80 minutes et au plus tard en 25 heures.

Quatrième série de fenêtres glissantes :

- $T_3$ : 1000 s
- $\Delta t^3$ : 20 s
- Durée totale de l'observation entre $t_1^3$ et $t_n^3 + T_3$ : 5000 s
- Chevauchement entre 2 fenêtres glissantes successives de durée $T_3$ : 400 s
- Nombre de confirmations au compteur $C_3$ avant détection d'un défaut : 3 défauts
- Temps avant remise à zéro du compteur $C_3$ si pas de défaut détecté : 8 heures

Ce qui signifie qu'un défaut qui se reproduit chaque seconde peut être confirmé au plus tôt en 4 heures et au plus tard en 24 heures.

Cinquième série de fenêtres glissantes :

- $T_4$ : 3600 s
- $\Delta t^4$ : 20 s
- Durée totale de l'observation entre $t_1^4$ et $t_n^4 + T_4$ : 10800 s
- Chevauchement entre 2 fenêtres glissantes successives de durée $T_4$ : 1440 s
- Nombre de confirmations au compteur $C_4$ avant détection d'un défaut : 2 défauts
- Temps avant remise à zéro du compteur $C_4$ si pas de défaut détecté : 12 h

Ce qui signifie qu'un défaut qui se reproduit chaque seconde peut être confirmé au plus tôt en 6 heures et au plus tard en 24 heures.

Pour les fenêtres de durées courtes, notamment de durées $T_0$, $T_1$ et $T_2$, la valeur absolue de l'erreur peut être considérée comme significative. Dans ces cas, les erreurs $e_{max}^{RMS}(T_0)$ , $e_{max}^{RMS}(T_1)$ et $e_{max}^{RMS}(T_2)$ peuvent être comparées, en vue d'incrémenter les compteurs $C_0$, $C_1$ et $C_2$ respectivement, à des seuils absolus en ampères (A), comme $ST_0 = 6A$, $ST_1 = 4A$ et $ST_2 = 2A$ respectivement. Alors que, pour les fenêtres de durées plus longues, notamment $T_3$ et $T_4$, la valeur absolue de l'erreur ne peut pas être considérée comme significative. En effet, lorsqu'on travaille sur des courtes périodes, c'est-à-dire à hautes fréquences, on surveille les pics de courant élevés et on raisonne donc en valeur absolue de l'erreur. Alors que pour les fréquences plus faibles, on cherche à surveiller la performance du système et donc on raisonne en pourcentage de réalisation de la consigne, qui correspond sensiblement à un rendement. Dans ces cas, ce sont les erreurs relatives $e_{max}^{RMS}(T_3)/courant\_moyen\_T_3$ et $e_{max}^{RMS}(T_4)/courant\_RMS\_T_4$ , où $courant\_moyen\_T_3$ et $courant\_RMS\_T_4$ désignent les courants moyens sur les périodes $T_3$ et $T_4$ respectivement, calculés par $\sqrt{\dfrac{1}{T_3}\displaystyle\int_{t}^{t+T_3}(I^{cons}(\tau))^2\,d\tau}$ et $\sqrt{\dfrac{1}{T_4}\displaystyle\int_{t}^{t+T_4}(I^{cons}(\tau))^2\,d\tau}$ respectivement, qui peuvent être comparées à des ratios comme 0,8 et 0,75 respectivement. Il faut noter que la décroissance des valeurs des seuils est importante afin de pouvoir distinguer les diagnostics les uns des autres. En effet, un soin particulier doit être apporté à la calibration des seuils afin de pouvoir distinguer séparément les différents diagnostics. Par exemple, un dépassement de 20A sur une période de 1 seconde correspond à un dépassement de 2A sur une plage de 10 secondes. Ainsi, si le diagnostic doit être effectué sur la fenêtre de 1 seconde et non par la fenêtre de 10 secondes, alors le seuil de la fenêtre 10 seconde doit être supérieur à 2A.

L'exemple de réalisation qui précède permet d'aider le personnel de maintenance à prendre les décisions adéquates en fonction du type de la panne :

- si une défaillance est détectée pour une durée $T_j$ de l'ordre de 1 à 10 secondes, alors le système peut être arrêté immédiatement et le personnel de maintenance peut être orienté vers des problèmes de connectique (tests de continuité) ou des problèmes d'instabilité du système (mises à jours logicielle) ;
- si une défaillance est détectée pour une durée $T_j$ de l'ordre de 100s, alors le personnel de maintenance peut être orienté vers des dérives de capteurs (changement de capteurs à prévoir) ;
- si une défaillance est détectée pour une durée $T_j$ de l'ordre de 1000 secondes ou plus, alors il s'agit probablement du phénomène de vieillissement et il faut alors prévoir de changer la batterie.

En fournissant un diagnostic précis quant à l'origine de la défaillance, un avantage supplémentaire de l'invention est donc de diminuer significativement les coûts de maintenance.

**Revendications**

1. Procédé pour détecter des défaillances dans un système de stockage d'énergie électrique comportant au moins une batterie, le procédé comportant :

   • une étape d'application d'une consigne de charge ou de décharge à la batterie, visant à ce qu'un courant théorique de consigne $I^{cons}$ traverse la batterie ;

• une étape de mesure du courant $I^{Bat}$ traversant la batterie pendant l'application de ladite consigne ;

le procédé étant **caractérisé en ce qu'**il comporte :

• une étape de calcul de $m \times n$ erreurs moyennes $(e_{T_j}(t_i^j))_{1 \leq j \leq m, 1 \leq i \leq n}$ entre le courant mesuré $I^{Bat}$ et le courant théorique de consigne $I^{cons}$ dans $m \times n$ intervalles temporels $([t_i^j, t_i^j + T_j])_{1 \leq j \leq m, 1 \leq i \leq n}$ respectivement, où m et n sont des entiers, $n \geq 2$ et $m \geq 1$, où pour tout j entre 1 et m et pour tout i entre 1 et n, $t_{i+1}^j = t_i^j + \Delta t_i^j$ où $\Delta t_i^j$ est un pas d'échantillonnage prédéterminé et où, pour tout j entre 1 et m, $T_i$ est une durée prédéterminée;

$$e_j = \max_{i=1,\ldots,n}(e_{T_j}(t_i^j)) ;$$

• une étape de calcul, pour tout j entre 1 et m, de
• une étape d'incrément d'un compteur $C_j$ si $e_j$ dépasse, en valeur absolue ou en part relative, un seuil prédéterminé ;

une défaillance étant détectée si $C_j$ dépasse un seuil prédéterminé.

2. Procédé selon la revendication 1, **caractérisé en ce que** le compteur $C_j$ est incrémenté si l'une des deux conditions suivantes est réalisée :

• $T_j$ est une durée inférieure à un seuil prédéterminé et $e_j$ dépasse un seuil prédéterminé en ampères, ou ;
• $T_j$ est une durée supérieure au seuil prédéterminé et le ratio entre $e_j$ et une erreur moyenne prédéterminée pour ladite durée $T_j$ dépasse un ratio prédéterminé.

3. Procédé selon la revendication 1, **caractérisé en ce que** l'erreur moyenne $e_{T_j}(t_i^j)$ est calculée par :

$$e_{T_j}(t_i^j) = e_{T_j}^{RMS}(t_i^j) = \sqrt{\frac{1}{T} \int_{t_i^j}^{t_i^j + T_j} (I^{Bat}(\tau) - I^{cons}(\tau))^2 d\tau}$$

4. Procédé selon la revendication 1, **caractérisé en ce qu'**il comporte en outre une étape de levée d'une alerte de défaillance, ladite alerte incluant d'indiquer :

• Si $T_j \leq seuil_1$, que la défaillance a pour origine une défaillance de connectique, où $seuil_1$ est un seuil temporel prédéterminé ;
• Si $seuil_1 \leq T_j \leq seuil_2$, que la défaillance a pour origine une défaillance de capteur, où $seuil_2$ est un seuil temporel prédéterminé ;
• Si $seuil_2 \leq T_j$, que la défaillance a pour origine le vieillissement de la batterie.

5. Système de stockage d'énergie électrique d'origine renouvelable comportant au moins une batterie, **caractérisé en ce qu'**il comporte des moyens matériels et des moyens logiciels pour mettre en œuvre le procédé selon l'une quelconque des revendications précédentes.

6. Bâtiment **caractérisé en ce qu'**il comporte un système selon la revendication précédente.

**Patentansprüche**

1. Verfahren zur Erkennung von Defekten in einem System zur Speicherung elektrischer Energie, das mindestens eine Batterie umfasst, wobei das Verfahren Folgendes umfasst:

• einen Schritt des Anwendens eines Lade- oder Entladesollwerts auf die Batterie, um einen theoretischen Sollwertstrom $I^{cons}$ durch die Batterie fließen zu lassen;
• einen Schritt des Messens des Stroms $I^{Bat}$, der während des Anwendens des Sollwerts durch die Batterie fließt;

wobei das Verfahren **dadurch gekennzeichnet ist, dass** es Folgendes umfasst:

• einen Schritt des Berechnens von $m \times n$ mittleren Fehlern $(e_{T_j}(t_i^j))_{1 \leq j \leq m, 1 \leq i \leq n}$ zwischen dem gemessenen Strom

$I^{Bat}$ und dem theoretischen Sollwertstrom $I^{cons}$ in jeweils $m \times n$ Zeitintervallen $([t_i^j, t_i^j + T_j])_{1 \leq j \leq m, 1 \leq i \leq n}$, wobei m und n ganze Zahlen sind, $n \geq 2$ und $m \geq 1$ ist, wobei für jedes j zwischen 1 und m und für jedes i zwischen 1 und n $t_{i+1}^j = t_i^j + \Delta t_i^j$, wobei $\Delta t_i^j$ ein vorgegebener Abtastschritt ist, und wobei für jedes j zwischen 1 und m $T_j$ eine vorgegebene Dauer ist;

- einen Schritt des Berechnens, für jedes j zwischen 1 und m, von
$$e_j = \max_{i=1,\ldots,n} \left( e_{T_j}(t_i^j) \right)$$ ;
- einen Schritt des Inkrementierens eines Zählers $C_j$, wenn $e_j$ als Absolutwert oder relativ gesehen einen vorgegebenen Schwellenwert überschreitet;

wobei ein Defekt erkannt wird, wenn $C_j$ einen vorgegebenen Schwellenwert überschreitet.

2. Verfahren nach Anspruch 1, **dadurch gekennzeichnet, dass** der Zähler $C_j$ inkrementiert wird, wenn eine der zwei folgenden Bedingungen erfüllt ist:

- $T_j$ ist eine Dauer, die kleiner als ein vorgegebener Schwellenwert ist, und $e_j$ überschreitet einen vorgegebenen Schwellenwert in Ampere, oder;
- $T_j$ ist eine Dauer, die größer als der vorgegebene Schwellenwert ist, und das Verhältnis zwischen $e_j$ und einem vorgegebenen mittleren Fehler für die Dauer $T_j$ überschreitet ein vorgegebenes Verhältnis.

3. Verfahren nach Anspruch 1, **dadurch gekennzeichnet, dass** der mittlere Fehler $e_{T_j}(t_i^j)$ wie folgt berechnet wird:

$$e_{T_j}(t_i^j) = e_{T_j}^{RMS}(t_i^j) = \sqrt{\frac{1}{T} \int_{t_i^j}^{t_i^j + T_j} \left( I^{Bat}(\tau) - I^{cons}(\tau) \right)^2 d\tau}$$

4. Verfahren nach Anspruch 1, **dadurch gekennzeichnet, dass** es ferner einen Schritt des Auslösens eines Defektalarms umfasst, wobei der Alarm die Angabe von Folgendem umfasst:

- wenn $T_j \leq$ Schwellenwert$_1$, dass der Ursprung des Defekts ein Anschlussdefekt ist, wobei der Schwellenwert$_1$ ein vorgegebener Zeitschwellenwert ist;
- wenn Schwellenwert$_1 \leq T_j \leq$ Schwellenwert$_2$, dass der Ursprung des Defekts ein Sensordefekt ist, wobei der Schwellenwert$_2$ ein vorgegebener Zeitschwellenwert ist;
- wenn Schwellenwert$_2 \leq T_j$, dass der Ursprung des Defekts die Alterung der Batterie ist.

5. System zur Speicherung elektrischer Energie aus erneuerbaren Energiequellen, das mindestens eine Batterie umfasst, **dadurch gekennzeichnet, dass** es Hardware und Software umfasst, um das Verfahren nach einem der vorhergehenden Ansprüche umzusetzen.

6. Gebäude, **dadurch gekennzeichnet, dass** es ein System nach dem vorhergehenden Anspruch umfasst.


**Claims**

1. Method for detecting faults in an electrical energy storage system including at least one battery, the method including:

- a step of applying a charge or discharge setpoint to the battery, aiming for a theoretical setpoint current $I^{cons}$ to pass through the battery;
- a step of measuring the current $I^{Bat}$ passing through the battery during the application of said setpoint;

the method being **characterized in that** it includes:

- a step of calculating $m \times n$ mean errors $(e_{T_j})(t_i^j))_{1 \leq j \leq m, 1 \leq i \leq n}$ between the measured current $I^{Bat}$ and the theoretical setpoint current $I^{cons}$ in $m \times n$ time intervals $([t_i^j, t_i^j + T_j])_{1 \leq j \leq m, 1 \leq i \leq n}$, respectively, where m and n are integers, $n \geq 2$ and $m \geq 1$, where for any value of j between 1 and m and for any value of i between 1 and n, $t_{i+1}^j = t_i^j + \Delta t_i^j$ where $\Delta t_i^j$ is a predetermined sampling interval and where, for any value of j between 1 and m, $T_j$ is a predetermined duration;

$$e_j = \max_{i=1,\dots,n}(e_{T_j}(t_i^j))$$

- a step of calculating, for any value of j between 1 and m, ;
- a step of incrementing a counter $C_j$ if $e_j$ exceeds a predetermined threshold in terms of absolute value or in terms of relative share;

a fault being detected if $C_j$ exceeds a predetermined threshold.

2. Method according to Claim 1, **characterized in that** the counter $C_j$ is incremented if one of the two following conditions is fulfilled:

- $T_j$ is a duration shorter than a predetermined threshold and $e_j$ exceeds a predetermined threshold for amperes, or;
- $T_j$ is a duration longer than the predetermined threshold and the ratio between $e_j$ and a predetermined mean error for said duration $T_j$ exceeds a predetermined ratio.

3. Method according to Claim 1, **characterized in that** the mean error $e_{T_j}(t_i^j)$ is calculated by:

$$e_{T_j}(t_i^j) = e_{T_j}^{RMS}(t_i^j) = \sqrt{\frac{1}{T} \int_{t_i^j}^{t_i^j + T_j} (I^{Bat}(\tau) - I^{cons}(\tau))^2 d\tau}$$

4. Method according to Claim 1, **characterized in that** it furthermore includes a step of raising a fault alarm, said alarm including indicating:

- if $T_j \leq threshold_1$, that the origin of the fault is a connector fault, where $threshold_1$ is a predetermined time threshold;
- if $threshold_1 \leq T_j \leq threshold_2$, that the origin of the fault is a sensor fault, where $threshold_2$ is a predetermined time threshold;
- if $threshold_2 \leq T_j$, that the origin of the fault is the ageing of the battery.

5. System for storing electrical energy from a renewable source, including at least one battery, **characterized in that** it includes hardware means and software means for implementing the method according to any one of the preceding claims.

6. Building, **characterized in that** it includes a system according to the preceding claim.

**Fig. 1**

**Fig. 2a**

**Fig. 2b**

**Fig. 2c**

**Fig. 2d**

**Fig. 3a**

$e_{T_0}^{RMS}(t_1)$ $e_{T_0}^{RMS}(t_2)$ $e_{T_0}^{RMS}(t_3)$

$e(\tau)$

$I^{bat}$

$\Rightarrow e_{max}^{RMS}(T_0)$

$\Delta t$

$t_1, t_1+T_0, T_1+2T_0, \ldots$

**Fig. 3b**

$e_{T_1}^{RMS}(t_1)$

$e_{T_1}^{RMS}(t_2)$

$e_{T_1}^{RMS}(t_3)$

$e(\tau)$

$I^{bat}$

$\Rightarrow e_{max}^{RMS}(T_1)$

$\Delta t$

$t_1 \quad t_2 \quad t_1+T_1$

**Fig. 3c**

$e_{T_2}^{RMS}(t_1)$ $e_{T_2}^{RMS}(t_2)$ $e_{T_2}^{RMS}(t_3)$

$e(\tau)$

$I^{bat}$

$\Rightarrow e_{max}^{RMS}(T_2)$

$\Delta t$

$t_1 \quad t_2 \quad t_1+T_2$

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- EP 2147323 A